# EUROPEAN PATENT APPLICATION

(11) **EP 4 835 958 A1**
(43) Date of publication of application: **04.11.2026**
(21) Application number: 25747516.0
(22) Date of filing: 14.01.2025
(51) Int. Cl.: H01L 21/67, H01L 21/683

(54) **CARRYING DEVICE, PROCESS CHAMBER AND SEMICONDUCTOR PROCESS APPARATUS**

(30) Priority: 02.02.2024 CN 202410150304
(71) Applicant: Beijing NAURA Microelectronics Equipment Co., Ltd., Beijing 100176 (CN)
(72) Inventor: MA, Jianqiang, Beijing 100176 (CN); WANG, Renliang, Beijing 100176 (CN)
(74) Representative: Cohausz & Florack
(86) International application number: PCT/CN2025/072208
(87) International publication number: WO 2025/161940

(57) **Abstract**

The present disclosure provides a carrier apparatus, a process chamber, and semiconductor process equipment. The carrier apparatus includes: a support assembly having a carrying surface at a top thereof and further having an introduction passage extending from a bottom of the support assembly to the carrying surface; a conductive assembly extending through the introduction passage and configured to be electrically connected to an electrostatic tray so as to feed an external voltage to an attraction electrode in the electrostatic tray; and a sealing assembly sleeved over an outer side of the conductive assembly and sealingly connected to the conductive assembly, the sealing assembly being connected to the bottom of the support assembly and being in sealing engagement with the support assembly so as to seal an end of the introduction passage located at the bottom of the support assembly. The solution of the present disclosure solves the sealing problem occurring in the process chamber when the electrostatic tray is separated from the carrier apparatus or when a sealing ring ages, thereby improving wafer quality.

## Description

### TECHNICAL FIELD

The present disclosure relates to the field of semiconductor manufacturing, and in particular, to a carrier apparatus, a process chamber, and semiconductor process equipment.

### BACKGROUND

A carrier apparatus and an electrostatic chuck are typically provided in semiconductor process equipment, where the carrier apparatus is disposed in a process chamber and is configured to support the electrostatic chuck, and the electrostatic chuck is configured to place a wafer.

The electrostatic chuck is fixedly connected to the carrier apparatus. A voltage feed structure is mounted on the carrier apparatus, and the voltage feed structure is configured to feed an external voltage to an attraction electrode of the electrostatic chuck, so that the attraction electrode generates an attraction force, thereby keeping the wafer fixed in position during the process. Under normal circumstances, since the electrostatic chuck is fixedly connected to the carrier apparatus, the voltage feed structure is not exposed within the process chamber. Therefore, it is unnecessary to consider the sealing issue between the voltage feed structure and the carrier apparatus.

However, in some related technologies, an electrostatic tray, rather than an electrostatic chuck, is provided at the carrier apparatus. The electrostatic tray is detachably connected to the carrier apparatus, which causes a portion of the voltage feed structure to be exposed inside the process chamber when the electrostatic tray is separated from the carrier apparatus. Therefore, the sealing of the related structures also needs to be considered to avoid sealing problems in the process chamber.

### SUMMARY

The present disclosure aims to solve at least one of the technical problems existing in the related art, and provides a carrier apparatus, a process chamber, and semiconductor process equipment, which can solve the sealing problem occurring in the process chamber in the related art when the electrostatic tray is separated from the carrier apparatus or when the sealing ring ages.

To achieve the purpose of the present disclosure, a carrier apparatus is disclosed, including: a support assembly, the top of the support assembly has a carrying surface for supporting an electrostatic tray, where the support assembly further includes an introduction passage, and the introduction passage extends from the bottom of the support assembly to the carrying surface; a conductive assembly, extending through the introduction passage, where the conductive assembly is configured to be electrically connected to the electrostatic tray so as to feed an external voltage to an attraction electrode in the electrostatic tray; and a sealing assembly, sleeved over the outer side of the conductive assembly and sealingly connected to the conductive assembly, where the sealing assembly is connected to the bottom of the support assembly and is in sealing engagement with the support assembly so as to seal the end of the introduction passage located at the bottom of the support assembly.

In some embodiments, the sealing assembly includes: an insulation sleeve having a first end and a second end opposite to each other, where the first end of the insulation sleeve is located inside the introduction passage, and the second end of the insulation sleeve is located outside the introduction passage; the insulation sleeve is in sealing engagement with the support assembly; and a sealing end cap sealingly and fixedly connected to the second end of the insulation sleeve, where the conductive assembly extends through the sealing end cap, and the conductive assembly is sealingly and fixedly connected to the sealing end cap.

In some embodiments, the sealing assembly further includes: a connection flange arranged around the insulation sleeve, where the connection flange is sealingly and fixedly connected to the outer wall of the insulation sleeve, and the connection flange is connected to and in sealing engagement with the support assembly so as to seal the end of the introduction passage located at the bottom of the support assembly.

In some embodiments, the carrier apparatus further includes: an annular sealing member disposed on the carrying surface of the support assembly, where the support assembly is configured such that, when supporting the electrostatic tray, an intervening space is formed between the carrying surface and the electrostatic tray, and the annular sealing member is configured to be sealingly connected between the carrying surface and the electrostatic tray so as to divide the intervening space into a mutually independent connection passage and a backside gas passage, where the connection passage is located at the inner side of the annular sealing member and communicates with the introduction passage, and the backside gas passage is located at the outer side of the annular sealing member and is configured for introducing gas.

In some embodiments, the conductive assembly includes: a conductive post having a first end and a second end, where the first end of the conductive post is located in the introduction passage, and the second end of the conductive post extends toward a direction away from the carrying surface to the outside of the introduction passage; the insulation sleeve is sleeved over the conductive post, and the conductive post extends through the sealing end cap and is sealingly connected to the sealing end cap; and an electrode probe connected to the first end of the conductive post, where the electrode probe is configured to be electrically connected to the electrostatic tray.

In some embodiments, the sealing assembly further includes: a protective sleeve sleeved between the conductive assembly and the insulation sleeve, where the inner wall of the protective sleeve is fitted against the outer wall of the conductive assembly, and the outer wall of the protective sleeve is fitted against the inner wall of the insulation sleeve.

In some embodiments, the carrier apparatus further includes: an insulation assembly sleeved between the conductive assembly and the inner wall of the introduction passage, and detachably connected to the sealing assembly.

In some embodiments, the insulation assembly includes: a protective cap sleeved over the conductive assembly, where a first assembly passage is provided inside the protective cap, and the electrode probe is located in the first assembly passage; and an insulation cap sleeved over the outer side of the protective cap, where the first end of the insulation cap extends to the end of the introduction passage adjacent to the carrying surface, the second end of the insulation cap faces the insulation assembly, and the outer wall of the insulation cap abuts against the inner wall of the introduction passage.

In some embodiments, the protective cap includes: a protective cap body having a first end and a second end, where the first end of the protective cap body is provided with a connection hole, the protective cap body is sleeved over the conductive assembly through the connection hole, a first assembly sub-passage is provided inside the protective cap body, one end of the first assembly sub-passage communicates with the connection hole, and another end of the first assembly sub-passage extends to the second end of the protective cap body; and an extension sleeve detachably connected to the second end of the protective cap body, where the interior of the extension sleeve communicates with the first assembly sub-passage to form the first assembly passage.

In some embodiments, the first end of the insulation cap is provided with a first limiting part, an inner peripheral wall of the introduction passage is provided with a second limiting part, and the first limiting part and the second limiting part are in limiting engagement, so that the support assembly limits the insulation cap within the introduction passage.

In some embodiments, the insulation assembly further includes: a buffer sleeve sleeved over the conductive assembly, where the first end of the buffer sleeve is in plug-in engagement with the insulation cap, and the second end of the buffer sleeve abuts against the sealing assembly.

In some embodiments, the support assembly further includes: a carrier plate, the top of the carrier plate has the carrying surface, where a first passage is provided in the carrier plate, and the first passage extends through the carrier plate from the bottom of the carrier plate to the top of the carrier plate; and an insulation cylinder having a first end and a second end, where the first end of the insulation cylinder abuts against the bottom of the carrier plate and is in sealing engagement with the carrier plate, the second end of the insulation cylinder is connected to and in sealing engagement with the connection flange, and a second passage extending from the first end of the insulation cylinder to the second end of the insulation cylinder is provided inside the insulation cylinder, where the second passage communicates with the first passage to form the introduction passage.

In some embodiments, the support assembly further includes: a support plate disposed at the second end of the insulation cylinder, where a through hole is provided in the support plate, the connection flange is disposed in the through hole and connected to the inner peripheral wall of the through hole, and the insulation sleeve extends through the through hole; and a support ring disposed between the support plate and the carrier plate, where the support ring is arranged around the insulation cylinder, the support ring is sealingly connected to the carrier plate, and the support ring is sealingly connected to the support plate.

In some embodiments, the insulation sleeve is made of a ceramic material, and/or the connection flange is made of an alloy material.

In some embodiments, the protective sleeve is made of a resin material.

In some embodiments, the protective cap is made of a resin material, and/or the insulation cap is made of a ceramic material.

In some embodiments, the buffer sleeve is made of a resin material.

According to a second aspect of the present disclosure, a process chamber is further disclosed, including: a chamber body and the above carrier apparatus, where the carrier apparatus is disposed in the chamber body and is in sealing engagement with the chamber body.

According to a third aspect of the present disclosure, semiconductor process equipment is further disclosed, including: an electrostatic tray detachably connected to the support assembly; a cassette module configured to store the electrostatic tray; a vacuum transfer module connected to the cassette module; and the above process chamber, where the chamber body is connected to the vacuum transfer module, and the electrostatic tray moves between the cassette module and the chamber body through the vacuum transfer module.

The present disclosure has the following beneficial effects:
In the technical solutions of the carrier apparatus, the process chamber, and the semiconductor process equipment provided by the present disclosure, when the carrier apparatus is disposed in the process chamber, by sleeving the sealing assembly over the outer side of the conductive assembly and sealingly connecting the sealing assembly to the conductive assembly, while connecting the sealing assembly to the bottom of the support assembly and placing the sealing assembly in sealing engagement with the support assembly, the end of the introduction passage extending to the bottom of the support assembly (i.e., the end of the introduction passage communicating with the exterior of the process chamber) can be sealed, that is, the gap between the conductive assembly and the inner wall of the introduction passage can be sealed, thereby effectively preventing external gas from entering the introduction passage through the gap between the inner wall of the introduction passage and the conductive assembly. Even if the end of the introduction passage located at the carrying surface is directly exposed in the process chamber, external gas still cannot enter the process chamber due to the sealing of the sealing assembly. Moreover, the sealing assembly achieves sealing with the support assembly and the conductive assembly respectively at the bottom of the support assembly. Compared with the related art in which sealing between the electrostatic tray and the carrier apparatus is achieved by a sealing ring, the sealing assembly is located farther away from the interior of the process chamber, is less affected by the high-temperature environment inside the chamber, is less prone to aging, and can therefore ensure long-term sealing performance.

### BRIEF DESCRIPTION OF THE DRAWINGS

FIG. 1 is a schematic structural diagram of a carrier apparatus in the related art;
FIG. 2 is a schematic structural diagram of the carrier apparatus according to an embodiment of the present disclosure;
FIG. 3 is a partial enlarged view of portion A in FIG. 2;
FIG. 4 is a schematic structural diagram of the sealing assembly of the carrier apparatus according to an embodiment of the present disclosure;
FIG. 5 is a partial enlarged view of portion B in FIG. 3;
FIG. 6 is an exploded view of the insulation assembly of the carrier apparatus according to an embodiment of the present disclosure;
FIG. 7 is a perspective view of the insulation cap of the insulation assembly of the carrier apparatus according to an embodiment of the present disclosure;
FIG. 8 is a schematic structural diagram of the support assembly of the carrier apparatus according to an embodiment of the present disclosure;
FIG. 9 is a schematic structural diagram of the process chamber according to an embodiment of the present disclosure;
FIG. 10 is a schematic structural diagram of the semiconductor process equipment according to an embodiment of the present disclosure;
FIG. 11 is a schematic structural diagram of the electrostatic tray of the semiconductor process equipment according to an embodiment of the present disclosure;
FIG. 12 is a schematic diagram of the backside gas pipeline of the semiconductor process equipment according to an embodiment of the present disclosure;

### Reference Numerals:

10, support assembly; 11, introduction passage; 111, second limiting part; 12, carrier plate; 121, first passage; 121a, first sub-passage; 121b, second sub-passage; 122, carrier plate body; 123, base; 13, insulation cylinder; 131, second passage; 14, support plate; 141, through hole; 142, inner flange; 15, support ring;
20, conductive assembly; 21, conductive post; 22, electrode probe; 221, probe body; 222, probe post;
30, sealing assembly; 31, insulation sleeve; 32, sealing end cap; 33, connection flange; 34, protective sleeve;
40, annular sealing member;
50, intervening space; 51, connection passage; 52, backside gas passage;
60, insulation assembly; 61, protective cap; 611, first assembly passage; 6111, first assembly sub-passage; 6112, second assembly sub-passage; 612, protective cap body; 6121, connection hole; 6122, annular insertion slot; 613, extension sleeve; 62, insulation cap; 621, first limiting part; 622, accommodation cavity; 623, installation passage; 63, buffer sleeve; 631, insertion protrusion; 6311, first insertion section; 6312, second insertion section;
71, first sealing ring; 72, second sealing ring; 73, third sealing ring; 74, fourth sealing ring; 75, fifth sealing ring; 76, sixth sealing ring; 77, seventh sealing ring;
100, chamber body; 110, mounting opening;
200, cassette module; 210, lifting mechanism;
300, vacuum transfer module; 310, vacuum robot; 320, first gate valve; 330, second gate valve;
400, electrostatic tray; 411, tray body; 4111, accommodation groove; 412, attraction electrode; 413, electrode feed post;
510, backside gas pipeline; 520, pressure controller; 530, backside gas source; 540, first control valve; 550, second control valve; 560, third control valve; 570, pump; 580, bypass; 590, exhaust pipeline.

### DETAILED DESCRIPTION OF THE EMBODIMENTS

To enable those skilled in the art to better understand the technical solutions of the present disclosure, the carrier apparatus, the process chamber, and the semiconductor process equipment provided by the present disclosure are described in detail below with reference to the accompanying drawings.

In semiconductor process equipment, a carrier apparatus and an electrostatic chuck are typically provided, where the carrier apparatus is disposed in a process chamber (PM, Process Module) and is configured to support the electrostatic chuck, and the electrostatic chuck is configured to place a wafer. The electrostatic chuck is fixedly connected to the carrier apparatus. A voltage feed structure is mounted on the carrier apparatus, and the voltage feed structure is configured to feed an external voltage to an attraction electrode of the electrostatic chuck, so that the attraction electrode generates an attraction force, thereby keeping the wafer fixed in position during the process. Under normal circumstances, since the electrostatic chuck is fixedly connected to the carrier apparatus, the voltage feed structure is not exposed within the process chamber. Therefore, it is unnecessary to consider the sealing issue between the voltage feed structure and the carrier apparatus.

However, in some related technologies, an electrostatic tray, rather than an electrostatic chuck, is provided at the carrier apparatus. The electrostatic tray is detachably connected to the carrier apparatus, which causes a portion of the voltage feed structure to be exposed inside the process chamber when the electrostatic tray is separated from the carrier apparatus. Therefore, the sealing of the related structures also needs to be considered to avoid sealing problems in the process chamber. Such sealing problems may affect the vacuum environment inside the process chamber, thereby affecting the quality of the wafer.

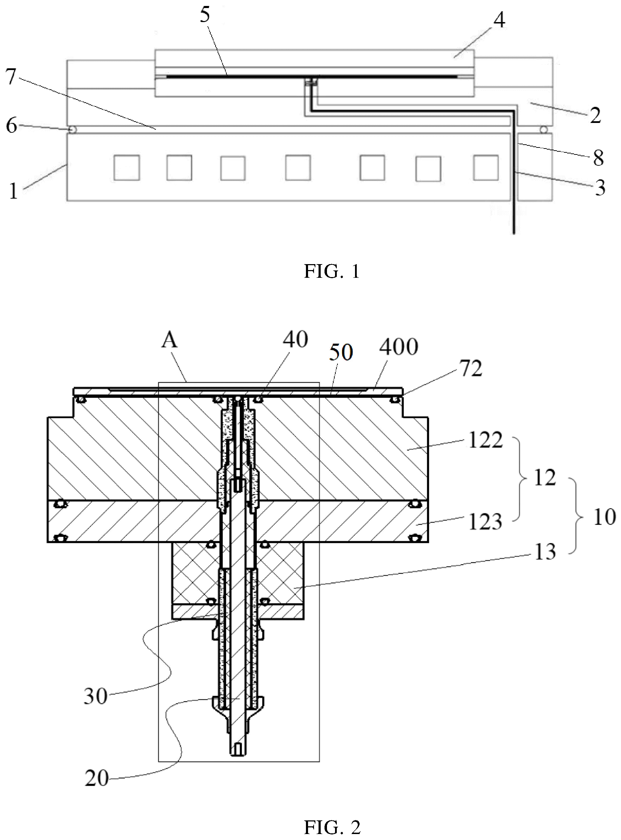

Specifically, in the related art shown in FIG. 1, the semiconductor process equipment includes: a carrier apparatus 1 and an electrostatic tray 2. The electrostatic tray 2 is configured to carry a wafer 4, and an attraction member 5 is provided inside the electrostatic tray 2 for attracting the wafer 4. An introduction passage 8 for mounting a voltage feed structure 3 is provided in the carrier apparatus 1. The voltage feed structure 3 is disposed in the introduction passage 8, one end of the voltage feed structure 3 is connected to an external power supply, and the other end extends to be electrically connected to the attraction member 5 inside the electrostatic tray 2, so as to be electrically conducted with the attraction member 5. During use, a probe of the voltage feed structure 3 can feed a DC voltage to the attraction member 5, and the electrostatic force generated by the attraction member 5 on the surface of the carrier apparatus 1 attracts the wafer 4.

As shown in FIG. 1, the electrostatic tray 2 and the carrier apparatus 1 are sealed by a sealing ring 6. Therefore, when the carrier apparatus 1 supports the electrostatic tray 2, neither the voltage feed structure 3 nor the introduction passage 8 is exposed inside the process chamber. Even if the introduction passage 8 communicates with the exterior of the process chamber, there is no need to worry that external gas will enter the process chamber through the gap between the voltage feed structure 3 and the introduction passage 8.

However, when the electrostatic tray 2 is separated from the carrier apparatus 1, the voltage feed structure 3 and the introduction passage 8 are directly exposed in the process chamber. Since the introduction passage 8 needs to communicate with the exterior, and the interior of the process chamber is in a vacuum state during the semiconductor process, external air can directly enter the process chamber through the gap between the voltage feed structure 3 and the introduction passage 8, thereby affecting the vacuum environment inside the process chamber and consequently affecting the quality of the wafer 4.

Moreover, the inventors have found through research that, when the electrostatic tray 2 is disposed at the carrier apparatus 1, the sealing ring 6 used for sealing between the electrostatic tray 2 and the carrier apparatus 1 is exposed to the high-temperature environment inside the process chamber. As a result, the sealing ring 6 is prone to aging after being used for a period of time. After the sealing performance decreases, this sealing manner still presents a risk that external air may enter the process chamber through the introduction passage 8, thereby affecting the quality of the wafer 4.

To solve the above problems, the embodiments of the present disclosure shown in FIGS. 2 to 4 disclose a carrier apparatus, including: a support assembly 10, a conductive assembly 20, and a sealing assembly 30. The top of the support assembly 10 has a carrying surface for supporting the electrostatic tray 400. The support assembly 10 further includes an introduction passage 11, and the introduction passage 11 extends from the bottom of the support assembly 10 to the carrying surface. The conductive assembly 20 extends through the introduction passage 11, and the conductive assembly 20 is configured to be electrically connected to the electrostatic tray 400 so as to feed an external voltage to the attraction electrode in the electrostatic tray 400. The sealing assembly 30 is sleeved over the outer side of the conductive assembly 20 and is sealingly connected to the conductive assembly 20. The sealing assembly 30 is connected to the bottom of the support assembly 10 and is in sealing engagement with the support assembly 10 so as to seal the end of the introduction passage 11 located at the bottom of the support assembly 10.

In the carrier apparatus provided by the embodiments of the present disclosure, by sleeving the sealing assembly 30 over the outer side of the conductive assembly 20 and sealingly connecting the sealing assembly 30 to the conductive assembly 20, while connecting the sealing assembly 30 to the bottom of the support assembly 10 and placing the sealing assembly 30 in sealing engagement with the support assembly 10, the end of the introduction passage 11 extending to the bottom of the support assembly 10 (i.e., the end of the introduction passage 11 communicating with the exterior of the process chamber) can be sealed, that is, the gap between the conductive assembly 20 and the inner wall of the introduction passage 11 can be sealed, thereby effectively preventing external gas from entering the introduction passage 11 through the gap between the inner wall of the introduction passage 11 and the conductive assembly 20. Even if the end of the introduction passage 11 located at the carrying surface is directly exposed in the process chamber, external gas still cannot enter the process chamber due to the sealing of the sealing assembly 30, thereby solving the sealing problem occurring in the process chamber in the related art when the electrostatic tray is separated from the carrier apparatus and consequently improving wafer quality.

When the carrier apparatus provided in the embodiments of the present disclosure is disposed in the process chamber, the bottom of the carrier apparatus is located outside the process chamber to facilitate the introduction of an external voltage. In this case, by assembling the sealing assembly 30 at the bottom of the support assembly 10, compared with the sealing ring 6 disposed between the electrostatic tray 2 and the carrier apparatus 1 in the related art, the sealing assembly 30 is located farther away from the interior of the process chamber, is less affected by the high-temperature environment inside the chamber, is less prone to aging, and can therefore ensure long-term sealing performance, thereby solving the sealing problem occurring in the process chamber in the related art when the sealing ring ages.

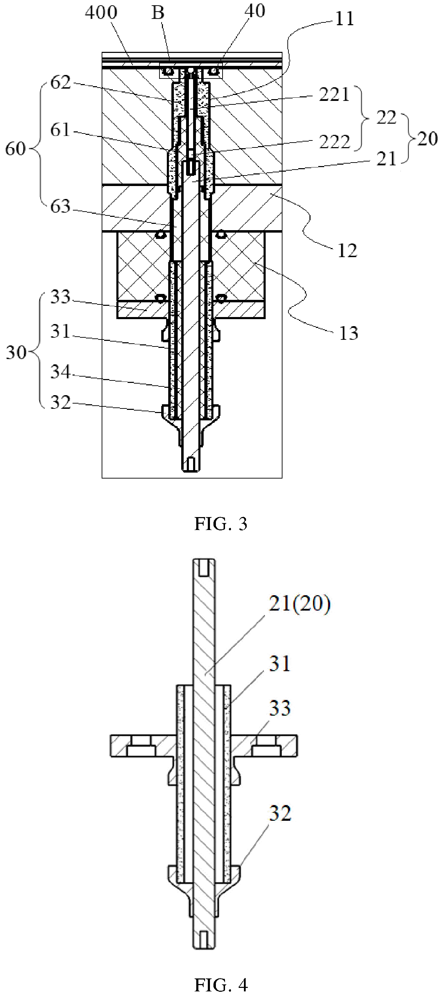

As shown in FIGS. 3 and 4, in the embodiments of the present disclosure, the sealing assembly 30 includes: an insulation sleeve 31 and a sealing end cap 32. The insulation sleeve 31 has a first end and a second end opposite to each other. The first end of the insulation sleeve 31 is located inside the introduction passage 11, and the second end of the insulation sleeve 31 is located outside the introduction passage 11. That is, as shown in FIG. 3, one end of the insulation sleeve 31 is inserted into the introduction passage 11 from the bottom of the support assembly 10, and the second end of the insulation sleeve 31 remains outside the support assembly 10. The conductive assembly 20 extends through the insulation sleeve 31. It is readily understood that a gap is formed between the conductive assembly 20 and the inner wall of the introduction passage 11 so as to reserve space for disposing the sealing assembly 30. The sealing end cap 32 is sealingly and fixedly connected to the second end of the insulation sleeve 31. The conductive assembly 20 extends through the sealing end cap 32, and the conductive assembly 20 is sealingly and fixedly connected to the sealing end cap 32. By providing the sealing end cap 32, the conductive assembly 20 can be fixedly connected to the insulation sleeve 31 through the sealing end cap 32, while also achieving a sealing connection between the conductive assembly 20 and the insulation sleeve 31 to prevent external gas from entering the process chamber through the gap between the conductive assembly 20 and the insulation sleeve 31. In the embodiments of the present disclosure, the insulation sleeve 31 is made of a ceramic material.

The insulation sleeve 31 is in sealing engagement with the support assembly 10. It should be noted that the insulation sleeve 31 and the support assembly 10 may be directly sealed by means of a sealing ring, or may be indirectly sealed by other components. In the embodiments of the present disclosure, sealing between the insulation sleeve 31 and the support assembly 10 is achieved indirectly.

In the embodiments of the present disclosure, as shown in FIG. 4, the sealing assembly 30 further includes: a connection flange 33 arranged around the insulation sleeve 31, where the connection flange 33 is sealingly and fixedly connected to the outer wall of the insulation sleeve 31. As shown in FIG. 3, the connection flange 33 is connected to and is in sealing engagement with the support assembly 10 so as to seal the end of the introduction passage 11 located at the bottom of the support assembly 10. In the embodiments of the present disclosure, the connection flange 33, for example, covers the position of the introduction passage 11 at the bottom of the support assembly 10, and the connection flange 33 is fixedly connected to the support assembly 10 by fasteners such as bolts. The insulation sleeve 31 is fixedly connected to the support assembly 10 through the connection flange 33, and a first sealing ring is provided between the connection flange 33 and the support assembly 10, thereby achieving sealing engagement.

By providing the connection flange 33, the connection flange 33 is fixedly and sealingly connected to the outer wall of the insulation sleeve 31, thereby effectively preventing external gas from entering the introduction passage 11 through the gap between the connection flange 33 and the insulation sleeve 31. Moreover, by providing the first sealing ring, a sealing connection can be formed between the connection flange 33 and the support assembly 10, thereby preventing external gas from entering the introduction passage 11 through the gap between the connection flange 33 and the support assembly 10, completely sealing the end of the introduction passage 11 located at the bottom of the support assembly 10, effectively preventing external air from entering the interior of the introduction passage 11, and thereby sealing the introduction passage 11.

In the embodiments of the present disclosure, the sealing end cap 32 and the connection flange 33 may be made of an aluminum alloy material or other materials. The conductive assembly 20 and the sealing end cap 32, the sealing end cap 32 and the insulation sleeve 31, and the insulation sleeve 31 and the connection flange 33 are all sealingly and fixedly connected by welding. However, this is not limiting. In some other embodiments not shown in the drawings, other connection methods, such as adhesive bonding, threaded connection, or a combination of threaded connection and a sealing structure, may also be used. Any connection method capable of achieving sealing and fixed connection falls within the scope of the present disclosure.

In the related art shown in FIG. 1, when the electrostatic tray 2 is disposed at the carrier apparatus 1, a backside gas passage 7 for introducing backside gas is formed among the electrostatic tray 2, the sealing ring 6, and the carrier apparatus 1, and the introduction passage 8 communicates with the backside gas passage 7. In the present disclosure, the backside gas refers to an inert gas introduced into the backside gas passage 7 during the semiconductor process, for example, helium. During operation of the equipment, a large amount of heat is generated due to ignition. In order to reduce the temperature of the electrostatic tray 2, helium is introduced into the backside gas passage 7 through the carrier apparatus 1 so that heat exchange is performed between the helium and the electrostatic tray 2, thereby reducing the temperature of the electrostatic tray 2. However, in the related art, because the voltage feed structure 3 needs to extend into the backside gas passage 7, the backside gas passage 7 communicates with the introduction passage 8, causing the backside gas to enter the introduction passage 8. During voltage feeding, the backside gas in the introduction passage 8 may discharge, resulting in arcing.

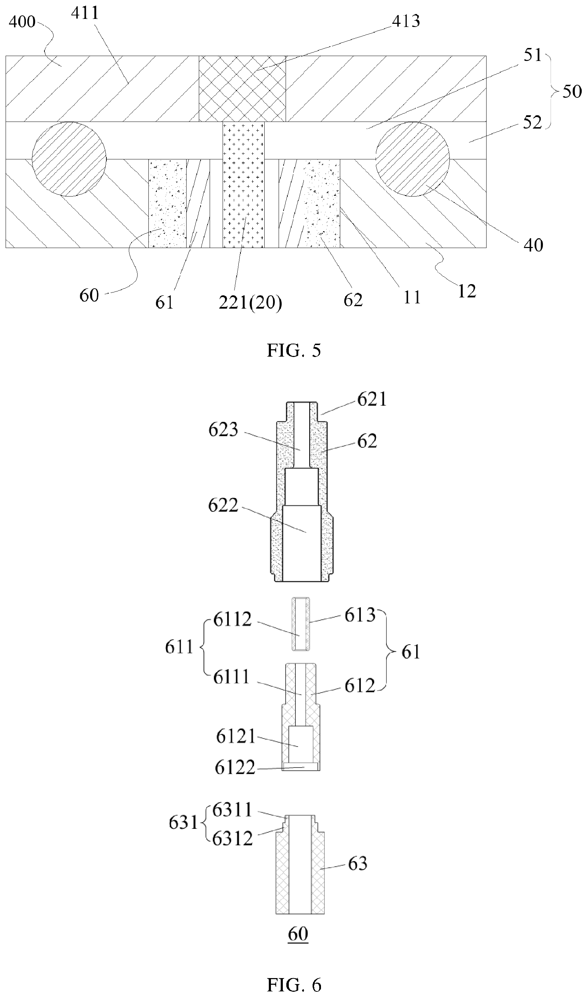

To solve the above problems, as shown in FIGS. 2 and 5, the carrier apparatus provided in the embodiments of the present disclosure further includes: an annular sealing member 40. The annular sealing member 40 is disposed on the carrying surface of the support assembly 10. The support assembly 10 is configured such that, when supporting the electrostatic tray 400, an intervening space 50 is formed between the carrying surface and the electrostatic tray 400. The annular sealing member 40 is configured to be sealingly connected between the carrying surface and the electrostatic tray 400 so as to divide the intervening space 50 into a mutually independent connection passage 51 and a backside gas passage 52. The connection passage 51 is located at the inner side of the annular sealing member 40 and communicates with the introduction passage 11, and the backside gas passage 52 is located at the outer side of the annular sealing member 40 for introducing gas, such as the above backside gas.

As shown in FIG. 5, after the electrostatic tray 400 is assembled, the annular sealing member 40 is provided in the intervening space 50 formed between the electrostatic tray 400 and the carrying surface, and the electrostatic tray 400 and the carrying surface are placed in sealing engagement through the annular sealing member 40. The annular sealing member 40 divides the intervening space 50 into two mutually independent and non-communicating parts, namely, the connection passage 51 located at the inner side of the annular sealing member 40 and the backside gas passage 52 located at the outer side of the annular sealing member 40. By communicating the connection passage 51 with the introduction passage 11 and isolating the introduction passage 11 from the backside gas passage 52 by means of the annular sealing member 40, after gas is introduced into the backside gas passage 52, the presence of the annular sealing member 40 can greatly reduce the amount of backside gas in the backside gas passage 52 entering the introduction passage 11, thereby reducing the risk of arcing in the introduction passage 11. In the embodiments of the present disclosure, the annular sealing member 40 is a sealing ring.

In the carrier apparatus provided in the embodiments of the present disclosure, by providing the annular sealing member 40 on the carrying surface for supporting the electrostatic tray 400, after the electrostatic tray 400 is assembled, the introduction passage 11 is isolated from the backside gas passage 52 by the annular sealing member 40. After gas is introduced into the backside gas passage 52, the presence of the annular sealing member 40 can reduce, to the greatest extent possible, the amount of backside gas entering the introduction passage 11, thereby reducing the risk of arcing in the introduction passage 11.

It can be understood that, in the embodiments of the present disclosure, the gas introduced into the backside gas passage 52 is backside gas, for example, helium.

It should be noted that, in the embodiments of the present disclosure, a second sealing ring 72 is further provided on the carrying surface. As shown in FIG. 2, the second sealing ring 72 is disposed at the edge of the carrying surface. After the electrostatic tray 400 is assembled on the carrying surface, the carrying surface, the bottom surface of the electrostatic tray 400, and the second sealing ring 72 jointly enclose the intervening space 50. The annular sealing member 40 is located at the inner side of the second sealing ring 72, and the backside gas passage 52 is formed between the annular sealing member 40 and the second sealing ring 72.

In the embodiments of the present disclosure, as shown in FIG. 3, the conductive assembly 20 includes: a conductive post 21 and an electrode probe 22. The conductive post 21 has a first end and a second end. The first end of the conductive post 21 is located in the introduction passage 11 and is connected to the electrode probe 22, so that, when the support assembly 10 supports the electrostatic tray 400, the conductive post 21 can be electrically connected to the electrostatic tray 400 through the electrode probe 22. The second end of the conductive post 21 extends toward a direction away from the carrying surface to the outside of the introduction passage 11 for electrical connection with an external power supply. The insulation sleeve 31 is sleeved over the conductive post 21. The conductive post 21 extends through the sealing end cap 32 and is sealingly connected to the sealing end cap 32. For example, the conductive post 21 and the sealing end cap 32 are sealingly and fixedly connected by welding.

In the embodiments of the present disclosure, the conductive post 21 and the electrode probe 22 are, for example, elastically connected. In this way, when the electrostatic tray 400 is placed on the support assembly 10, a buffering effect can be achieved while ensuring good electrical contact between the electrostatic tray 400 and the electrode probe 22. It can be understood that the electrode probe 22 includes a probe body 221 and a probe post 222. The probe body 221 and the probe post 222 are elastically connected, and the probe post 222 is fixedly connected to the conductive post 21 by welding or an interference fit.

It should be noted that, in the embodiments of the present disclosure, both the conductive post 21 and the electrode probe 22 are made of conductive materials, preferably copper. However, this is not limiting. In some other embodiments not shown in the drawings, the conductive post 21 and the probe may also be made of other conductive materials, such as gold, silver, or the like.

In the related art shown in FIG. 1, since the wall of the introduction passage 8 is made of a metal material, the metal material dissipates the voltage fed from the DC power supply to the electrostatic tray 2, making it impossible to ensure that the entire voltage is applied to the electrostatic tray 2, thereby affecting the electrostatic attraction performance.

To solve the above problems, as shown in FIG. 3, the sealing assembly 30 further includes: a protective sleeve 34. The protective sleeve 34 is sleeved between the conductive assembly 20 (for example, the conductive post 21) and the insulation sleeve 31. The inner wall of the protective sleeve 34 is fitted against the outer wall of the conductive assembly 20 (for example, the conductive post 21), and the outer wall of the protective sleeve 34 is fitted against the inner wall of the insulation sleeve 31. In the embodiments of the present disclosure, the protective sleeve 34 is, for example, made of a resin material (for example, polyetherimide, which is a super engineering plastic having high temperature resistance, high dimensional stability, chemical resistance, flame retardancy, electrical properties, high strength, and high rigidity). By providing the protective sleeve 34, the insulation sleeve 31 is prevented from colliding with and being damaged by the conductive post 21, thereby providing a buffering effect. In addition, since the insulation sleeve 31 and the protective sleeve 34 have insulation properties, while providing insulation and protection, they can also effectively fill the gap between the conductive post 21 and the inner wall of the introduction passage 11, thereby reducing the amount of backside gas and avoiding arcing. At the same time, current loss can be effectively reduced, and the entire voltage fed by the DC power supply can be ensured to be applied to the electrostatic tray 400, increasing the electrostatic charge induced on the upper surface of the electrostatic tray 400, and thereby improving wafer attraction.

As shown in FIG. 3, the carrier apparatus includes: an insulation assembly 60. The insulation assembly 60 is sleeved between the conductive assembly 20 and the inner wall of the introduction passage 11, and is detachably connected to the sealing assembly 30. In this way, the sealing assembly 30 and the insulation assembly 60 together occupy most of the space in the gap between the conductive assembly 20 and the introduction passage 11. First, the resistance between the conductive assembly 20 and the inner wall of the passage can be increased, thereby making arcing more difficult to occur. Second, since the sealing assembly 30 and the insulation assembly 60 occupy most of the space in the gap, gas (for example, helium) that passes through the annular sealing member 40 and enters the introduction passage 11 can be displaced, thereby reducing the amount of gas in the gap between the conductive assembly 20 and the introduction passage 11 and consequently reducing the risk of arcing. Third, by enclosing the conductive assembly 20 with the sealing assembly 30 and the insulation assembly 60, current on the conductive assembly 20 can be prevented from flowing to the support assembly 10, thereby further reducing current loss and ensuring that the entire voltage fed by the DC power supply is applied to the electrostatic tray 400.

In addition, by detachably connecting the insulation assembly 60 and the sealing assembly 30, during installation, the insulation assembly 60 and the sealing assembly 30 can be installed respectively from the two ends of the conductive assembly 20, and during disassembly, the insulation assembly 60 and the sealing assembly 30 can be removed separately, making the installation and disassembly processes more flexible and convenient.

Specifically, in the embodiment in which the conductive assembly 20 includes the conductive post 21 and the electrode probe 22, and the sealing assembly 30 includes the insulation sleeve 31, the insulation assembly 60 is sleeved over the portion of the conductive post 21 adjacent to the first end thereof, the electrode probe 22 extends through the insulation assembly 60, and the insulation assembly 60 is detachably connected to the insulation sleeve 31.

In the carrier apparatus provided by the embodiments of the present disclosure, by providing the annular sealing member 40, the conductive assembly 20, the sealing assembly 30, and the insulation assembly 60, the amount of backside gas entering the introduction passage 11 is first reduced by the annular sealing member 40, and then the gap within the introduction passage 11 is filled by the sealing assembly 30 and the insulation assembly 60. This not only improves the insulation between the conductive assembly 20 and the inner wall of the passage, but also displaces the backside gas within the introduction passage 11. Through the combined effect of reducing the amount of backside gas and displacing the backside gas, the conditions for gas discharge and arcing are eliminated, thereby not only preventing arcing, but also further increasing the effective voltage fed by the DC power supply and ensuring the stability of wafer attraction by the electrostatic tray 400.

Further, in some embodiments, as shown in FIGS. 3 and 6, the insulation assembly 60 includes: a protective cap 61 and an insulation cap 62. The protective cap 61 is sleeved over the conductive assembly 20, for example, over the portion of the conductive post 21 adjacent to the first end thereof. A first assembly passage 611 is provided inside the protective cap 61, and the electrode probe 22 is located in the first assembly passage 611. The insulation cap 62 is sleeved over the outer side of the protective cap 61. The first end of the insulation cap 62 extends to the end of the introduction passage 11 adjacent to the carrying surface, the second end of the insulation cap 62 faces the insulation sleeve 31, and the outer wall of the insulation cap 62 abuts against the inner wall of the introduction passage 11. In the embodiments of the present disclosure, the insulation cap 62 is made of a ceramic material and is relatively hard, while the conductive assembly 20 (for example, including the conductive post 21 and the electrode probe 22) is made of a metal material. If the conductive assembly 20 directly contacts the ceramic insulation cap 62, collisions are likely to occur, resulting in damage to the insulation cap 62. Based on this, by providing the protective cap 61 between the conductive assembly 20 (for example, including the conductive post 21 and the electrode probe 22) and the insulation cap 62, collisions between the conductive assembly 20 and the insulation cap 62 can be prevented, specifically collisions between the conductive post 21 and the insulation cap 62 and between the electrode probe 22 and the insulation cap 62, thereby protecting the insulation cap 62. Meanwhile, the protective cap 61 is made of an insulation material and also provides insulation. For example, the protective cap 61 is made of a resin material (for example, polytetrafluoroethylene, which is a polymer prepared by polymerizing tetrafluoroethylene monomers and has excellent heat resistance and cold resistance. Meanwhile, polytetrafluoroethylene is resistant to high temperatures and has an extremely low coefficient of friction, facilitating assembly). Compared with ceramic, this material is softer, provides a buffering effect, and resin is also an insulation material and provides insulation. Through the cooperation of the protective cap 61 and the insulation cap 62, while providing insulation and protection, the gap between the conductive assembly 20 and the inner wall of the introduction passage 11 can also be filled, thereby reducing the amount of backside gas, avoiding arcing, preventing current from flowing to the support assembly 10, and thereby increasing the effective voltage fed by the DC power supply.

In one embodiment shown in FIG. 6, the protective cap 61 includes: a protective cap body 612 and an extension sleeve 613. The protective cap body 612 has a first end and a second end. The first end of the protective cap body 612 is provided with a connection hole 6121, and the protective cap body 612 is sleeved over the conductive assembly 20 through the connection hole 6121, for example, over the portion of the conductive post 21 adjacent to the first end thereof. Further, in some embodiments, the inner wall of the connection hole 6121 is provided with an internal thread, and the outer peripheral surface of the portion of the conductive post 21 adjacent to the first end thereof is provided with an external thread, so that the connection hole 6121 and the conductive post 21 are fixed by threaded connection. By adopting the threaded connection between the connection hole 6121 and the conductive post 21, during assembly, the protective cap body 612 can be connected and fixed to the conductive post 21 by threaded connection, facilitating subsequent installation and positioning and improving assembly efficiency and assembly accuracy.

As shown in FIG. 6, a first assembly sub-passage 6111 is provided inside the protective cap body 612. One end of the first assembly sub-passage 6111 communicates with the connection hole 6121, and the other end of the first assembly sub-passage 6111 extends to the second end of the protective cap body 612. The extension sleeve 613 is detachably connected to the second end of the protective cap body 612. A second assembly sub-passage 6112 is provided inside the extension sleeve 613, and the second assembly sub-passage 6112 communicates with the first assembly sub-passage 6111 to form the first assembly passage 611. During assembly, the protective cap body 612 may first be fixed to the conductive post 21 by threaded connection, then the electrode probe 22 is inserted into the first assembly sub-passage 6111 and connected to the conductive post 21 therein, and finally the extension sleeve 613 is sleeved over the electrode probe 22 to complete the assembly. By configuring the protective cap body 612 and the extension sleeve 613 detachable, installation of the probe is facilitated, thereby improving assembly efficiency.

It can be understood that, in the embodiments of the present disclosure, the thickness of the outer wall of the protective cap body 612 corresponding to the connection hole 6121 is greater than the thickness of the first end of the protective cap body 612. By increasing the thickness of the outer wall of the protective cap body 612 corresponding to the connection hole 6121, the reliability and insulation performance of the protective cap body 612 sleeved over the conductive assembly 20 can be improved.

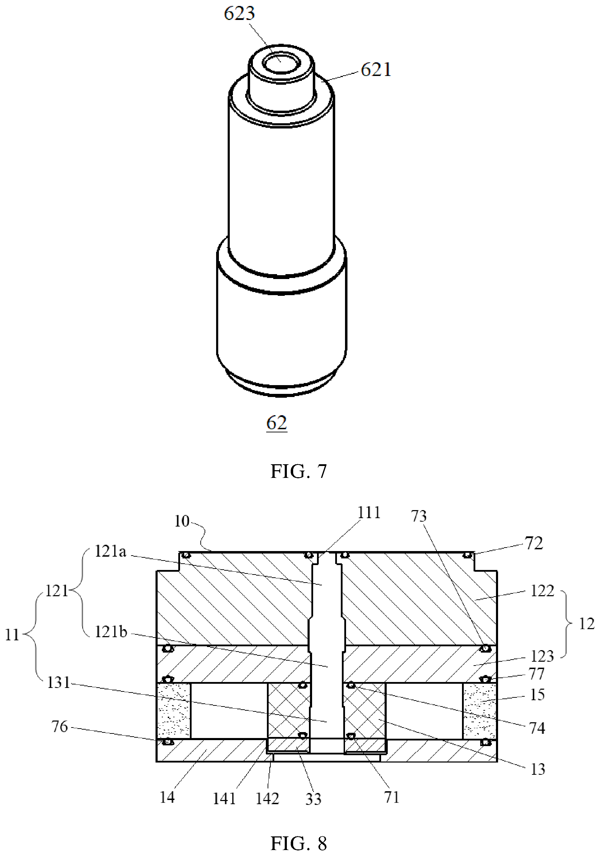

As shown in FIGS. 6 to 8, the insulation cap 62 has a first end and a second end. The first end of the insulation cap 62 extends to the position of the carrying surface, and the second end of the insulation cap 62 extends in a direction away from the carrying surface. The first end of the insulation cap 62 is located at the passage opening of the introduction passage 11 on the carrying surface. A first limiting part 621 is provided at the outer peripheral wall of the first end of the insulation cap 62. At the end of the introduction passage 11 adjacent to the carrying surface, as shown in FIG. 8, a second limiting part 111 is provided at the inner peripheral wall of the introduction passage 11. The first limiting part 621 and the second limiting part 111 are in limiting engagement, so that the support assembly 10 limits the insulation cap 62 within the introduction passage 11.

In the embodiments of the present disclosure, the first limiting part 621 is an annular groove, and the second limiting part 111 is an annular protrusion. However, this is not limiting. In some other embodiments not shown in the drawings, the first limiting part 621 and the second limiting part 111 may also be other limiting structures, such as a limiting post and a limiting groove or the like. Any structure capable of achieving axial limiting and limiting the insulation cap 62 within the introduction passage 11 falls within the scope of the present disclosure.

As shown in FIG. 6, inside the insulation cap 62, the insulation cap 62 has an accommodation cavity 622 for accommodating the protective cap body 612 and an installation passage 623 for inserting the extension sleeve 613. The contour of the accommodation cavity 622 matches the contour of the protective cap body 612, so that the inner wall of the accommodation cavity 622 is tightly fitted against the outer wall of the protective cap body 612, thereby reducing gaps where backside gas may exist. Similarly, the inner wall of the installation passage 623 is also tightly fitted against the outer wall of the extension sleeve 613, thereby reducing gaps where backside gas may exist. However, it should be noted that, although the outer wall of the protective cap body 612 is tightly fitted against the inner wall of the accommodation cavity 622, and the inner wall of the installation passage 623 is also tightly fitted against the outer wall of the extension sleeve 613, for ease of installation and disassembly, the protective cap body 612 and the inner wall of the accommodation cavity 622 may still move axially relative to each other, so that the protective cap body 612 can be inserted into the accommodation cavity 622. Correspondingly, the extension sleeve 613 and the inner wall of the installation passage 623 may also move axially relative to each other, so as to facilitate installation of the extension sleeve 613.

As shown in FIG. 6, the insulation assembly 60 further includes: a buffer sleeve 63. The buffer sleeve 63 is sleeved over the conductive assembly 20, for example, over the conductive post 21. The first end of the buffer sleeve 63 is in plug-in engagement with the insulation cap 62, and the second end of the buffer sleeve 63 abuts against the sealing assembly 30, for example, against the insulation sleeve 31. The main function of the buffer sleeve 63 is to provide a buffering effect between the insulation cap 62 and the sealing assembly 30 while ensuring insulation, so as to avoid damage caused by collision between the insulation cap 62 and the sealing assembly 30. Specifically, taking the case where both the insulation cap 62 and the insulation sleeve 31 are made of ceramic materials as an example, the buffer sleeve 63 may be made of a softer insulation material. For example, the buffer sleeve 63 is made of a resin material (for example, polytetrafluoroethylene, which is a polymer prepared by polymerizing tetrafluoroethylene monomers and has excellent heat resistance and cold resistance. Meanwhile, polytetrafluoroethylene is resistant to high temperatures and has an extremely low coefficient of friction, facilitating assembly). The main function thereof is to buffer the insulation cap 62 and the insulation sleeve 31 while ensuring insulation, so as to avoid damage caused by collision between the insulation cap 62 and the insulation sleeve 31.

In the embodiment in which the conductive assembly 20 includes the conductive post 21 and the electrode probe 22, and the sealing assembly 30 includes the insulation sleeve 31, as shown in FIG. 6, an insertion protrusion 631 is provided at the first end of the buffer sleeve 63. The insertion protrusion 631 is in plug-in engagement with the protective cap 61 and the insulation cap 62, and the second end of the buffer sleeve 63 abuts against the insulation sleeve 31. The insertion protrusion 631 includes a first insertion section 6311 and a second insertion section 6312 distributed in the axial direction, and the outer peripheral size of the first insertion section 6311 is smaller than the outer peripheral size of the second insertion section 6312. Referring to FIG. 6, an annular insertion slot 6122 is provided at the inner wall of the connection hole 6121 and at a position adjacent to the first end of the protective cap body 612. After the insertion protrusion 631 is inserted into the second end of the insulation cap 62, the second insertion section 6312 is in plug-in engagement with the inner wall of the accommodation cavity 622, and the first insertion section 6311 is in plug-in engagement with the annular insertion slot 6122. By providing the insertion protrusion 631, the buffer sleeve 63 can be inserted and fixed to the protective cap 61 and the insulation cap 62 through the insertion protrusion 631, thereby improving connection reliability. Meanwhile, the insertion protrusion 631 can also cooperate with the protective cap 61 and the insulation cap 62 through the two insertion sections (i.e., the first insertion section 6311 and the second insertion section 6312), respectively, thereby positioning the protective cap 61 and the insulation cap 62 and improving assembly accuracy.

It can be understood that, as shown in FIG. 7, at the position of the insulation cap 62 corresponding to the conductive post 21, that is, the portion of the insulation cap 62 enclosing the accommodation cavity 622, the inner wall of the insulation cap 62 is thicker so as to improve the insulation.

It should be noted that, in the embodiments of the present disclosure, the electrostatic tray 400 is detachably connected to the support assembly 10. In the present disclosure, detachable connection means that the electrostatic tray 400 is movable. In other words, the electrostatic tray 400 is placed on the support assembly 10. During wafer transfer, the electrostatic tray 400 can be directly removed, and the wafer on the electrostatic tray 400 is moved together with the electrostatic tray 400. This approach avoids direct contact between the wafer transfer equipment and the wafer, thereby effectively preventing wafer damage. Moreover, the electrostatic tray 400 can be removed more conveniently, facilitating cleaning of the electrostatic tray 400 after removal.

When the movable electrostatic tray 400 is used, after the electrostatic tray 400 is placed on the support assembly 10, the cooperation of the annular sealing member 40, the sealing assembly 30, and the insulation assembly 60 can effectively reduce the amount of backside gas in the introduction passage 11, thereby avoiding arcing.

As shown in FIG. 8, in the embodiments of the present disclosure, the support assembly 10 includes: a carrier plate 12 and an insulation cylinder 13. The carrier plate 12 is provided with a first passage 121 extending from the bottom of the carrier plate 12 to the top of the carrier plate 12. The top of the carrier plate 12 has a carrying surface, and when the electrostatic tray 400 is assembled, the electrostatic tray 400 is assembled on the carrying surface at the top of the carrier plate 12. The first end of the insulation cylinder 13 abuts against the bottom of the carrier plate 12 and is in sealing engagement with the carrier plate 12. The second end of the insulation cylinder 13 is connected to and in sealing engagement with the connection flange 33. For example, the connection may be fixed by fasteners such as bolts, and a first sealing ring 71 is provided between the connection flange 33 and the insulation cylinder 13 to achieve sealing engagement therebetween. A second passage 131 is provided inside the insulation cylinder 13. The second passage 131 extends from the first end of the insulation cylinder 13 to the second end of the insulation cylinder 13, and the second passage 131 communicates with the first passage 121 to form the introduction passage 11.

In the carrier apparatus provided by the embodiments of the present disclosure, by providing the insulation cylinder 13, the connection flange 33 can be fixedly connected to the carrier plate 12 through the insulation cylinder 13, thereby fixing the support assembly 10 and the sealing assembly 30 relative to each other. In addition, sealing engagement between the connection flange 33 and the insulation cylinder 13 is achieved by the first sealing ring 71, thereby preventing external air from entering the introduction passage 11 and improving the sealing effect. Furthermore, the insulation cylinder 13 also isolates the carrier plate 12 from the connection flange 33, thereby preventing electrical conduction between the carrier plate 12 and the connection flange 33 and consequently preventing radio frequency leakage.

In the embodiments of the present disclosure, the carrier plate 12 includes a carrier plate body 122 and a base 123. The top of the carrier plate body 122 has the carrying surface. A first sub-passage 121a is provided in the vertical direction in the carrier plate body 122, and the insulation cap 62 is installed in the first sub-passage 121a. The first end of the first sub-passage 121a extends to the carrying surface at the top of the carrier plate body 122, and the second end of the first sub-passage 121a extends to the bottom of the carrier plate body 122. A second sealing ring 72 is provided at the edge of the carrying surface on the top of the carrier plate body 122. When the electrostatic tray 400 is placed on the carrier plate body 122, the backside gas passage 52 is formed among the inner side of the second sealing ring 72, the outer side of the annular sealing member 40, the top surface of the carrier plate body 122 and the bottom surface of the electrostatic tray 400.

The base 123 is disposed at the bottom of the carrier plate body 122. A third sealing ring 73 is provided between the base 123 and the carrier plate body 122. A second sub-passage 121b is provided in the vertical direction in the base 123, and the second sub-passage 121b communicates with the first sub-passage 121a to form the first passage 121. The insulation cylinder 13 abuts against the base 123, and a fourth sealing ring 74 is provided between the insulation cylinder 13 and the base 123, so that the insulation cylinder 13 and the base 123 are in sealing engagement through the fourth sealing ring 74.

As shown in FIG. 8, the support assembly 10 further includes: a support plate 14 and a support ring 15. The support plate 14 is disposed at the second end of the insulation cylinder 13. A through hole 141 is provided in the support plate 14. The connection flange 33 is disposed in the through hole 141 and is connected to the inner peripheral wall of the through hole 141, and the insulation sleeve 31 extends through the through hole 141. The support ring 15 is disposed between the support plate 14 and the carrier plate 12. The support ring 15 is arranged around the insulation cylinder 13. The support ring 15 is sealingly connected to the carrier plate 12, and the support ring 15 is sealingly connected to the support plate 14. By providing the support plate 14 and the support ring 15, the carrier plate 12 can be connected to the process chamber through the support plate 14 and the support ring 15, thereby completing assembly of the carrier apparatus. To facilitate installation, an inner flange 142 is provided at the inner peripheral wall of the through hole 141. During assembly, the inner flange 142 supports and positions the connection flange 33.

The assembly relationship between the carrier apparatus and the process chamber is described in detail below with reference to a specific application scenario:

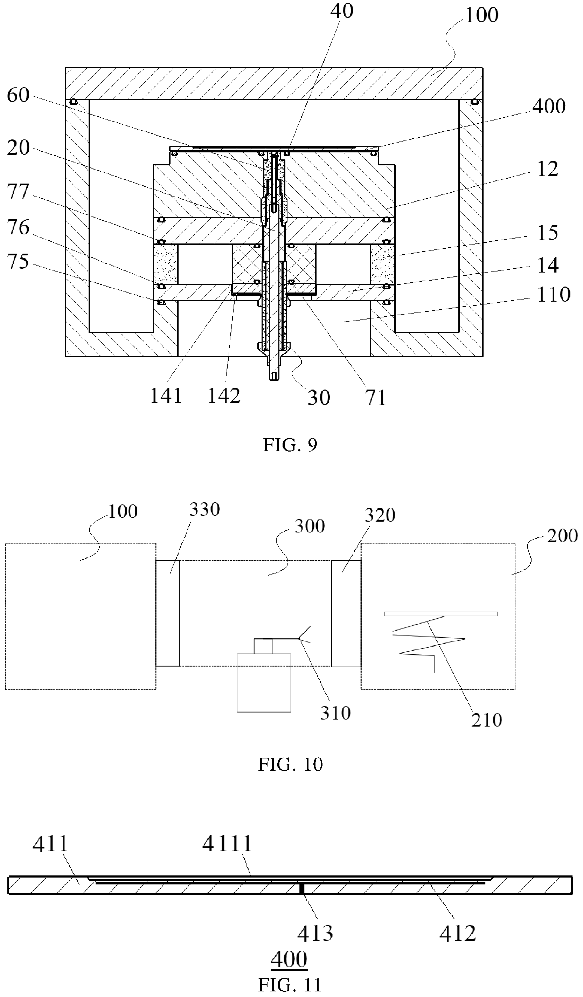

As shown in FIG. 9, the embodiments of the present disclosure further disclose a process chamber, including: a chamber body 100 and the above carrier apparatus, where the carrier apparatus is disposed in the chamber body 100 and is in sealing engagement with the chamber body 100.

A mounting opening 110 is provided at the bottom of the chamber body 100. The support plate 14 is disposed inside the chamber body 100 and covers the mounting opening 110. A fifth sealing ring 75 is provided between the support plate 14 and the chamber body 100 so that the support plate 14 is in sealing engagement with the bottom wall of the chamber body 100, thereby sealing the mounting opening 110.

A support ring 15 is further disposed above the support plate 14. A sixth sealing ring 76 is provided between the support ring 15 and the support plate 14 to seal the gap therebetween, thereby placing the support ring 15 and the support plate 14 in sealing engagement. The base 123 of the carrier plate 12 is disposed at the support ring 15. A seventh sealing ring 77 is provided between the base 123 and the support ring 15 to place the base 123 and the support ring 15 in sealing engagement. The support ring 15 is made of an insulation material to prevent electrical conduction between the carrier plate 12 and the support plate 14. The connection flange 33 is located in the through hole 141 and is in sealing engagement with the inner wall of the through hole 141. The insulation cylinder 13 is disposed at and fixedly connected to the connection flange 33, and the insulation sleeve 31 extends through the through hole 141 to the exterior of the chamber body 100.

As can be seen from FIGS. 3 and 9, after assembly, the sealing end cap 32 and the second end of the conductive post 21 are located outside the chamber body 100. However, because the sealing end cap 32 and the conductive post 21 are sealingly connected, the sealing end cap 32 and the insulation sleeve 31 are sealingly connected, and the connection flange 33 and the insulation sleeve 31 are sealingly connected, external air can be effectively prevented from entering the introduction passage 11 through the gap between the conductive post 21 and the sealing end cap 32, the gap between the sealing end cap 32 and the insulation sleeve 31, or the gap between the connection flange 33 and the insulation sleeve 31. Correspondingly, external air can be effectively prevented from entering the introduction passage 11 through these gaps, thereby preventing external air from entering the chamber body 100 through the introduction passage 11.

It can also be seen from FIGS. 3, 8, and 9 that, since sealing rings are provided between the base 123 and the support ring 15, between the support plate 14 and the support ring 15, and between the support plate 14 and the chamber body 100, external air can be effectively prevented from directly entering the chamber body 100, thereby improving the overall sealing performance. In addition, since the connection flange 33 and the insulation cylinder 13 are in sealing engagement, and the insulation cylinder 13 and the base 123 are in sealing engagement, external gas can also be prevented from entering the introduction passage 11, thereby improving the reliability of the overall sealing. Even when the electrostatic tray 400 is not provided, that is, when the interior of the introduction passage 11 is directly exposed inside the chamber body 100, external air is still prevented from entering the chamber body 100 through the introduction passage 11, thereby achieving effective sealing.

In the process chamber provided by the embodiments of the present disclosure, the annular sealing member 40 is provided inside the carrier apparatus to isolate the introduction passage 11 from the backside gas passage 52. After backside gas is introduced into the backside gas passage 52, the presence of the annular sealing member 40 reduces, to the greatest extent possible, the amount of backside gas entering the introduction passage 11, thereby reducing the risk of arcing in the introduction passage 11. Moreover, the voltage feed structure formed by the conductive assembly 20, the sealing assembly 30, and the insulation assembly 60 can effectively prevent external gas from entering the introduction passage 11, thereby isolating the introduction passage 11 from the external environment. Even when the electrostatic tray 400 is not provided, sealing inside the process chamber can still be ensured, thereby improving the reliability of the sealing of the process chamber.

As shown in FIG. 10, the embodiments of the present disclosure further disclose semiconductor process equipment, including: a cassette module (CM, Cassette Module) 200, a vacuum transfer module (TM, Transfer Module) 300, an electrostatic tray 400, and the above process chamber (including the chamber body 100). The cassette module 200 is configured to store wafers or the electrostatic tray 400. The cassette module 200 is a chamber capable of switching between vacuum and atmosphere, and a lifting mechanism 210 for moving wafers or the electrostatic tray 400 is provided therein.

A vacuum robot 310 is provided inside the vacuum transfer module 300, and the vacuum robot 310 transfers wafers or the electrostatic tray 400 between the process chamber (including the chamber body 100) and the cassette module 200.

The cassette module 200 is connected to the vacuum transfer module 300 through a first gate valve 320, and the vacuum transfer module 300 is connected to the process chamber (including the chamber body 100) through a second gate valve 330. When a gate valve is opened, the two adjacent chambers communicate with each other. When the gate valve is closed, the two adjacent chambers are isolated from each other.

In the embodiments of the present disclosure, as shown in FIG. 11, the electrostatic tray 400 includes: a tray body 411, an attraction electrode 412, and an electrode feed post 413. The tray body 411 is circular and made of a ceramic material. An accommodation groove 4111 for placing a wafer is provided on the front surface (that is, the top surface) of the tray body 411 to prevent the wafer from sliding on the electrostatic tray 400. In order to achieve automatic centering of the wafer relative to the electrostatic tray 400 during placement of the wafer, the sidewall of the accommodation groove 4111 is inclined, so that the edge of the wafer can slide along the inclined sidewall into the bottom of the accommodation groove 4111, thereby completing the automatic centering process. A backside gas hole (not shown) extending through the tray body 411 to the bottom surface thereof is further provided at the bottom of the accommodation groove 4111. Referring to FIGS. 2 and 3, when the electrostatic tray 400 is placed on the carrier plate 12, the backside gas hole communicates with the backside gas passage 52, so that the backside gas in the backside gas passage 52 enters the accommodation groove 4111 through the backside gas hole to cool the wafer. The attraction electrode 412 is disposed in the tray body 411 below the accommodation groove 4111, and the attraction electrode 412 is made of copper. The electrode feed post 413 is embedded in the tray body 411. One end of the electrode feed post 413 is electrically connected to the attraction electrode 412, and the other end extends to the back surface (that is, the bottom surface) of the tray body 411. The electrode feed post 413 is made of copper and is configured to introduce a DC voltage.

It should be noted that, in the embodiments of the present disclosure, one accommodation groove 4111 is provided at the electrostatic tray 400. However, this is not limiting. In some other embodiments not shown in the drawings, a plurality of accommodation grooves 4111 may also be provided, for example, 2, 3, 4, 5, or the like. The size of the tray body 411 and the size and number of the accommodation grooves 4111 may be adjusted according to actual needs and the size of the wafer.

The conductive assembly 20 is disposed in the introduction passage 11 and is configured to abut against the bottom of the electrostatic tray 400 so as to contact and be electrically connected to the electrode feed post 413 at the bottom of the electrostatic tray 400, and feed an external DC voltage to the attraction electrode 412 through the electrode feed post 413, so that the attraction electrode 412 generates an electrostatic attraction force for attracting the wafer.

Referring to FIGS. 5 and 11, when the electrostatic tray 400 is placed on the carrier plate 12, the probe body 221 in the conductive assembly 20 abuts against the electrode feed post 413 of the electrostatic tray 400, thereby electrically connecting the conductive post 21 to the electrode feed post 413, so that the external voltage is fed to the attraction electrode 412 of the electrostatic tray 400 to achieve wafer attraction.

In the embodiments of the present disclosure, the electrostatic tray 400 is detachably connected to the support assembly 10. Detachable connection means that the electrostatic tray 400 is movable. In other words, the electrostatic tray 400 is placed on the support assembly 10. During wafer transfer, the electrostatic tray 400 can be directly removed, and the wafer on the electrostatic tray 400 is moved together with the electrostatic tray 400. This approach avoids direct contact between the wafer transfer equipment and the wafer, thereby effectively preventing wafer damage. Moreover, the electrostatic tray 400 can be removed more conveniently, facilitating cleaning of the electrostatic tray 400 after removal.

In the semiconductor process equipment of this embodiment, when the electrostatic tray 400 carrying a wafer needs to be transported from the cassette module 200 to the process chamber (including the chamber body 100), the overall process is as follows:

Transport process: The cassette module 200 is evacuated. After the interior reaches a preset vacuum level, the lifting mechanism 210 raises the electrostatic tray 400 to a preset wafer-transfer waiting position. The first gate valve 320 at the cassette module 200 side is then opened, and the vacuum robot 310 passes through the first gate valve 320 to remove the electrostatic tray 400 from the cassette module 200, after which the first gate valve 320 is closed. At this time, the second gate valve 330 at the process chamber (including the chamber body 100) side is opened, the vacuum robot 310 transfers the electrostatic tray 400 into the process chamber (including the chamber body 100), which is also under vacuum, and places the electrostatic tray 400 on the support assembly 10. The vacuum robot 310 is then retracted, and the second gate valve 330 is closed.

Fabrication process: Voltage is fed to the electrostatic tray 400 through the conductive assembly 20, and backside gas (helium) is introduced into the backside gas passage 52 at the back surface (bottom surface) of the electrostatic tray 400. The attraction status of the electrostatic tray 400 is detected, and after confirming that the wafer has been attracted, the subsequent etching process is performed. After the process is completed, the radio frequency power is turned off (first the power loaded by the lower radio frequency power supply is turned off, and then the power loaded by the upper radio frequency power supply is turned off), the process gas is turned off, the process chamber (including the chamber body 100) is evacuated, the backside gas is turned off, and the applied voltage of the electrostatic tray 400 is turned off.

Electrostatic tray 400 unloading process: The second gate valve 330 is opened, and the electrostatic tray 400 is removed from the process chamber (including the chamber body 100) by the vacuum robot 310. The second gate valve 330 is then closed, the first gate valve 320 is opened, and the robot transfers the electrostatic tray 400 into the cassette module 200.

It should be noted that, when the movable electrostatic tray 400 is used, after the electrostatic tray 400 is placed on the carrier plate 12, the annular sealing member 40 isolates the introduction passage 11 from the backside gas passage 52. After backside gas is introduced into the backside gas passage 52, the presence of the annular sealing member 40 reduces, to the greatest extent possible, the amount of backside gas entering the introduction passage 11, thereby reducing the risk of arcing in the introduction passage 11. Moreover, the sealing assembly 30 and the insulation assembly 60 are provided to fill the introduction passage 11, thereby increasing the resistance between the conductive assembly 20 and the inner wall of the introduction passage 11. Through the cooperation of the annular sealing member 40, the sealing assembly 30, and the insulation assembly 60, the amount of backside gas in the introduction passage 11 can be effectively reduced, thereby avoiding arcing.

After the electrostatic tray 400 is separated from the carrier plate 12, the sealing assembly 30 seals the end of the introduction passage 11 communicating with the exterior (that is, the end of the introduction passage 11 located at the bottom of the support assembly 10). Therefore, external gas is prevented from entering the process chamber (including the chamber body 100) through the introduction passage 11, thereby isolating the introduction passage 11 from the external environment. Correspondingly, even when the electrostatic tray 400 is not provided, sealing inside the process chamber (including the chamber body 100) can still be ensured, thereby improving the reliability of the sealing of the process chamber.

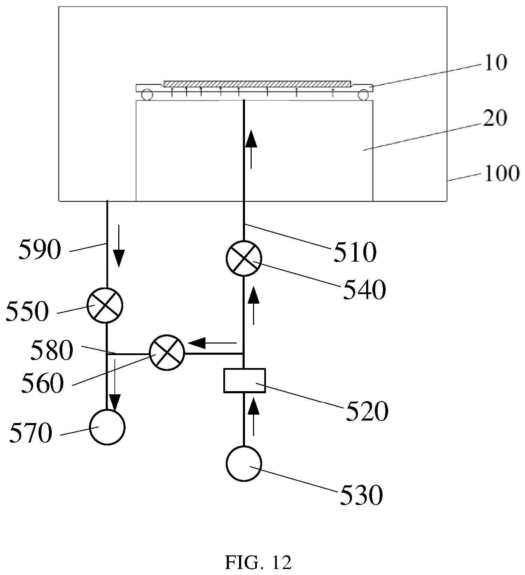

It should be noted that, as shown in FIG. 12, in some embodiments, the semiconductor process equipment has a backside gas pipeline 510 for introducing backside gas and a pressure controller 520 disposed in the backside gas pipeline 510. The backside gas passage 52 communicates with the backside gas source 530 through the backside gas pipeline 510. The pressure controller 520 is disposed at the backside gas pipeline 510 and is configured to control the backside gas pressure in the backside gas pipeline 510, and can also detect the backside gas flow rate in the backside gas pipeline 510.

Specifically, as shown in FIG. 12, the semiconductor process equipment further includes a first control valve 540, a second control valve 550, a third control valve 560, and a pump 570.

The first control valve 540 is disposed at the backside gas pipeline 510 and is configured to control opening and closing of the backside gas pipeline 510. The third control valve 560 is disposed at the bypass 580. One end of the bypass 580 is connected to the backside gas pipeline 510, and the other end of the bypass 580 is connected to the pump 570. The third control valve 560 is configured to control opening and closing of the bypass 580. The second control valve 550 is configured to control opening and closing of the exhaust pipeline 590 that delivers gas discharged from the chamber body 100 to the pump 570.

When introducing backside gas, the first control valve 540 and the second control valve 550 are closed, and the third control valve 560 is opened. At this time, the backside gas flows through the bypass 580 and is delivered to the pump 570. During this process, the pressure value of the introduced backside gas can be set through the pressure controller 520. At this time, the backside gas flow rate of the bypass 580 under the current pressure can be obtained through the pressure controller 520 and used as the preset flow rate value corresponding to the set pressure. During normal processing, the first control valve 540 and the third control valve 560 are opened, while the second control valve 550 remains closed. If the electrostatic tray 400 has attracted the wafer, the difference between the flow rate obtained by the pressure controller 520 under the current pressure and the preset flow rate value corresponding to the current pressure (i.e., the backside gas flow rate of the bypass 580) is less than 1 sccm. If the difference between the flow rate obtained by the pressure controller 520 under the current pressure and the preset flow rate value corresponding to the current pressure (i.e., the backside gas flow rate of the bypass 580) is greater than 1 sccm, it indicates that the electrostatic tray 400 has not attracted the wafer.

The pressure value for introducing the backside gas is generally set to 8 Torr. When the first control valve 540 and the second control valve 550 are closed and the third control valve 560 is opened, the pressure controller 520 displays the backside gas flow rate of the bypass 580 at that pressure value. Taking, as an example, the case where the equipment defines the above preset flow rate value (i.e., the backside gas flow rate of the bypass 580) as 2 sccm, when the first control valve 540 and the third control valve 560 are opened, if the backside gas flow rate corresponding to a backside gas pressure of 8 T displayed by the pressure controller 520 is approximately 2.5 sccm, the difference between that value and the preset flow rate value corresponding to the current pressure (i.e., the backside gas flow rate of the bypass 580) is less than 1 sccm, indicating that the electrostatic tray 400 has attracted the wafer. If the backside gas flow rate corresponding to a backside gas pressure of 8 T displayed by the pressure controller 520 exceeds 3 sccm, the difference between that value and the preset flow rate value corresponding to the current pressure (i.e., the backside gas flow rate of the bypass 580) is greater than 1 sccm, indicating that the electrostatic tray 400 has not attracted the wafer.

It can be understood that the above embodiments are merely exemplary embodiments adopted to illustrate the principles of the present disclosure, and the present disclosure is not limited thereto. Those of ordinary skill in the art may make various modifications and improvements without departing from the spirit and essence of the present disclosure, and such modifications and improvements are also regarded as falling within the scope of the present disclosure.

## Claims

1. A carrier apparatus, comprising:
a support assembly, a top of the support assembly having a carrying surface for supporting an electrostatic tray, wherein the support assembly further includes an introduction passage extending from a bottom of the support assembly to the carrying surface;
a conductive assembly extending through the introduction passage and configured to be electrically connected to the electrostatic tray so as to feed an external voltage to an attraction electrode in the electrostatic tray;
a sealing assembly sleeved over an outer side of the conductive assembly and sealingly connected to the conductive assembly, wherein the sealing assembly is connected to the bottom of the support assembly and is in sealing engagement with the support assembly so as to seal an end of the introduction passage located at the bottom of the support assembly.

2. The carrier apparatus according to claim 1, wherein the sealing assembly includes:
an insulation sleeve having a first end and a second end opposite to each other, the first end of the insulation sleeve being located inside the introduction passage, the second end of the insulation sleeve being located outside the introduction passage, and the insulation sleeve being in sealing engagement with the support assembly;
a sealing end cap sealingly and fixedly connected to the second end of the insulation sleeve, the conductive assembly extending through the sealing end cap and sealingly and fixedly connected to the sealing end cap.

3. The carrier apparatus according to claim 2, wherein the sealing assembly further includes:
a connection flange arranged around the insulation sleeve and sealingly and fixedly connected to an outer wall of the insulation sleeve, the connection flange being connected to and in sealing engagement with the support assembly so as to seal the end of the introduction passage located at the bottom of the support assembly.

4. The carrier apparatus according to claim 1, further comprising:
an annular sealing member disposed on the carrying surface of the support assembly, wherein the support assembly is configured such that, when supporting the electrostatic tray, an intervening space is formed between the carrying surface and the electrostatic tray, the annular sealing member is configured to be sealingly connected between the carrying surface and the electrostatic tray so as to divide the intervening space into a connection passage and a backside gas passage that are independent of each other, the connection passage is located at an inner side of the annular sealing member and communicates with the introduction passage, and the backside gas passage is located at an outer side of the annular sealing member and is configured for introducing gas.

5. The carrier apparatus according to claim 2, wherein the conductive assembly includes:
a conductive post having a first end and a second end, the first end of the conductive post being located in the introduction passage, the second end of the conductive post extending toward a direction away from the carrying surface to outside of the introduction passage, the insulation sleeve being sleeved over the conductive post, and the conductive post extending through the sealing end cap and being sealingly connected to the sealing end cap;
an electrode probe connected to the first end of the conductive post and configured to be electrically connected to the electrostatic tray.

6. The carrier apparatus according to any one of claims 2 to 5, wherein the sealing assembly further includes:
a protective sleeve sleeved between the conductive assembly and the insulation sleeve, an inner wall of the protective sleeve being fitted against an outer wall of the conductive assembly, and an outer wall of the protective sleeve being fitted against an inner wall of the insulation sleeve.

7. The carrier apparatus according to any one of claims 1 to 5, further comprising:
an insulation assembly sleeved between the conductive assembly and an inner wall of the introduction passage, and detachably connected to the sealing assembly.

8. The carrier apparatus according to claim 7, wherein the insulation assembly includes:
a protective cap sleeved over the conductive assembly, a first assembly passage being provided inside the protective cap, and the electrode probe being located in the first assembly passage;
an insulation cap sleeved over an outer side of the protective cap, a first end of the insulation cap extending to an end of the introduction passage adjacent to the carrying surface, a second end of the insulation cap facing the insulation assembly, and an outer wall of the insulation cap abutting against the inner wall of the introduction passage.

9. The carrier apparatus according to claim 8, wherein the protective cap includes:
a protective cap body having a first end and a second end, the first end of the protective cap body being provided with a connection hole, the protective cap body being sleeved over the conductive assembly through the connection hole, a first assembly sub-passage being provided inside the protective cap body, one end of the first assembly sub-passage communicating with the connection hole, and another end of the first assembly sub-passage extending to the second end of the protective cap body;
an extension sleeve detachably connected to the second end of the protective cap body, an interior of the extension sleeve communicating with the first assembly sub-passage to form the first assembly passage.

10. The carrier apparatus according to claim 8, wherein:
the first end of the insulation cap is provided with a first limiting part, an inner peripheral wall of the introduction passage is provided with a second limiting part, and the first limiting part and the second limiting part are in limiting engagement so that the support assembly limits the insulation cap within the introduction passage.

11. The carrier apparatus according to claim 8, wherein the insulation assembly further includes:
a buffer sleeve sleeved over the conductive assembly, a first end of the buffer sleeve being in plug-in engagement with the insulation cap, and a second end of the buffer sleeve abutting against the sealing assembly.

12. The carrier apparatus according to claim 3, wherein the support assembly further includes:
a carrier plate, a top of the carrier plate having the carrying surface, a first passage being provided in the carrier plate and extending from a bottom of the carrier plate to the top of the carrier plate;
an insulation cylinder having a first end and a second end, the first end of the insulation cylinder abutting against the bottom of the carrier plate and being in sealing engagement with the carrier plate, the second end of the insulation cylinder being connected to and in sealing engagement with the connection flange, a second passage extending from the first end of the insulation cylinder to the second end of the insulation cylinder being provided inside the insulation cylinder, and the second passage communicating with the first passage to form the introduction passage.

13. The carrier apparatus according to claim 12, wherein the support assembly further includes:
a support plate disposed at the second end of the insulation cylinder, a through hole being provided in the support plate, the connection flange being disposed in the through hole and connected to an inner peripheral wall of the through hole, and the insulation sleeve extending through the through hole;
a support ring disposed between the support plate and the carrier plate and arranged around the insulation cylinder, the support ring being sealingly connected to the carrier plate, and the support ring being sealingly connected to the support plate.

14. The carrier apparatus according to claim 3, wherein:
the insulation sleeve is made of a ceramic material; and/or
the connection flange is made of an alloy material.

15. The carrier apparatus according to claim 6, wherein:
the protective sleeve is made of a resin material.

16. The carrier apparatus according to claim 8, wherein:
the protective cap is made of a resin material; and/or
the insulation cap is made of a ceramic material.

17. The carrier apparatus according to claim 11, wherein:
the buffer sleeve is made of a resin material.

18. A process chamber, comprising a chamber body and the carrier apparatus according to any one of claims 1 to 17, wherein the carrier apparatus is disposed in the chamber body and is in sealing engagement with the chamber body.

19. Semiconductor process equipment, comprising:
an electrostatic tray detachably connected to the support assembly;
a cassette module configured to store the electrostatic tray;
a vacuum transfer module connected to the cassette module; and
the process chamber according to claim 18, wherein the chamber body is connected to the vacuum transfer module, and the electrostatic tray moves between the cassette module and the chamber body through the vacuum transfer module.
